# DEMANDE DE BREVET EUROPEEN

(11) **EP 4 531 104 A1**
(43) Date de publication de la demande: **02.04.2025**
(21) Numéro de dépôt: 24201681.4
(22) Date de dépôt: 20.09.2024
(51) Int. Cl.: H01L 25/07, G01R 31/26, H01L 21/66, H01L 25/16

(54) **CIRCUIT ELECTRONIQUE**

(30) Priorité: 26.09.2023 FR 2310184
(71) Demandeur: STMicroelectronics International N.V., 1228 Plan-les-Ouates, Geneva (CH)
(72) Inventeur: GODILLON, Jonathan, 31520 RAMONVILLE-SAINT-AGNE (FR)
(74) Mandataire: Cabinet Beaumont

(57) **Abrégé**

La présente description concerne un circuit électronique comprenant une première puce, ayant un transistor GaN, et une deuxième puce, empilées de sorte qu'un élément de la deuxième puce connecte électriquement un premier noeud et un deuxième noeuds de la première puce reliés respectivement à un noeud de conduction et à un noeud de commande du transistor GaN.

## Description

### Domaine technique

La présente description concerne de façon générale les circuits électroniques et les procédés associés.

### Technique antérieure

Lors de la fabrication d'un circuit électronique, il peut être utile de tester certains composants du circuit avant que le circuit ne soit complètement finalisé ou assemblé avec d'autres circuits.

### Résumé de l'invention

Il existe un besoin de fournir des circuits électroniques dont des composants peuvent être testés au cours de la fabrication et ce en minimisant les coûts de fabrication et de conception.

Un mode de réalisation pallie tout ou partie des inconvénients des circuits connus.

Un mode de réalisation prévoit un circuit électronique comprenant une première puce, ayant un transistor GaN, et une deuxième puce, empilées de sorte qu'un élément de la deuxième puce connecte électriquement un premier noeud et un deuxième noeuds de la première puce reliés respectivement à un noeud de conduction et à un noeud de commande du transistor GaN.

Un mode de réalisation prévoit un procédé de fabrication d'un circuit électronique comprenant :
- empiler une première puce, ayant un transistor GaN et une deuxième puce, de sorte qu'un élément de la deuxième puce connecte électriquement un premier noeud et un deuxième noeuds de la première puce reliés respectivement à un noeud de conduction et à un noeud de commande du transistor GaN.

Dans un mode de réalisation, ledit élément de la deuxième puce comprend une piste conductrice agencée sur une première face de la deuxième puce.

Dans un mode de réalisation, la deuxième puce est une puce à base de silicium.

Dans un mode de réalisation, la deuxième puce comprend au moins un transistor.

Dans un mode de réalisation, le transistor de la deuxième puce est de type MOS et le transistor GaN de la première puce est de type HEMT.

Dans un mode de réalisation, ledit transistor de la deuxième puce a :
- un premier noeud de conduction connecté au premier noeud de la première puce par l'intermédiaire dudit élément, et
- un deuxième noeud de conduction connecté au noeud de commande du transistor de la première puce par l'intermédiaire d'un autre élément.

Dans un mode de réalisation, un contact électrique entre ledit élément de la deuxième puce et les premiers et deuxième noeuds de la première puce est une soudure ou une brasure.

Dans un mode de réalisation, le deuxième noeud de la première puce est relié au noeud de commande du transistor GaN par l'intermédiaire d'un composant électronique.

Dans un mode de réalisation, ledit composant électronique est actif ou passif.

Dans un mode de réalisation, ledit composant électronique est configuré pour permettre l'établissement d'un point de fonctionnement automatique du transistor GaN.

Dans un mode de réalisation, ledit composant électronique est une résistance.

Dans un mode de réalisation, avant l'empilement de la première et de la deuxième puces, les premier et deuxième noeuds de la première puce sont déconnectés l'un de l'autre.

Dans un mode de réalisation, avant l'empilement de la première et de la deuxième puces, un test du composant électronique est réalisé.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre schématiquement une partie d'un circuit électronique selon un mode de réalisation ;
la figure 2 illustre une vue de dessus de la partie de circuit électronique du mode de réalisation de la figure 1 ;
la figure 3 illustre schématiquement une vue de dessus d'un mode de réalisation d'un circuit électronique ;
la figure 4 illustre schématiquement une vue en coupe A-A d'une partie du circuit électronique du mode de réalisation de la figure 3 ;
la figure 5 illustre schématiquement le circuit électronique de la figure 3 selon un mode de réalisation ; et
la figure 6 illustre un procédé de fabrication du circuit électronique de la figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

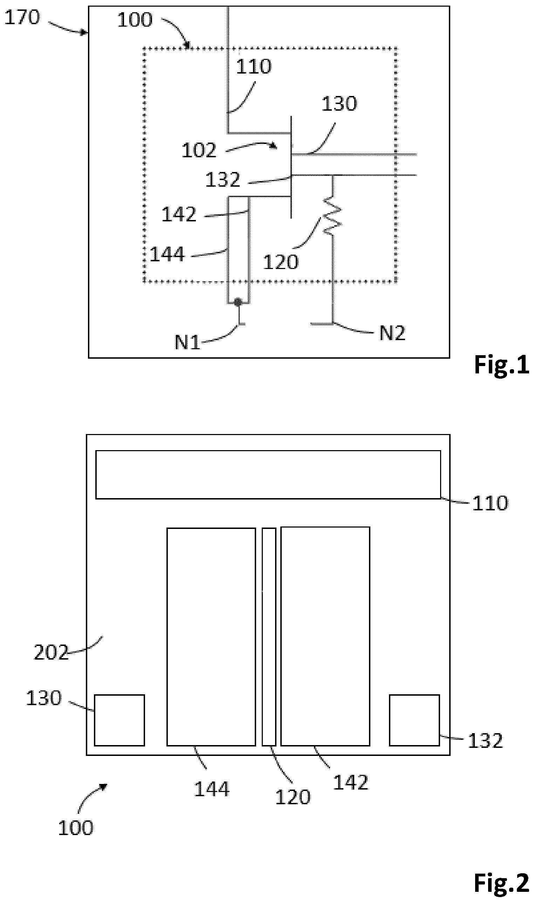

La figure 1 illustre schématiquement un circuit électronique 170 selon un mode de réalisation.

Plus particulièrement, la figure 1 représente un premier circuit du circuit électronique 170 formé dans une première puce 100 qui comporte un transistor GaN 102. Un premier noeud N1 de la première puce 100 est relié à un noeud de conduction 142, 144, par exemple la source, du transistor GaN 102. Un deuxième noeud N2 de la première puce 100 est relié à un noeud de commande 130,132, par exemple la grille, du transistor GaN 102. Le transistor 102 comprend également un autre noeud de conduction 110 par exemple le drain.

Dans l'exemple représenté, le noeud de conduction 142, 144 et le noeud de commande 130, 132 comprennent deux pistes chacun, il est toutefois possible d'envisager une seule piste pour chacun d'eux.

Dans un exemple, le transistor GaN est de type à haute mobilité d'électrons (High-Electron-Mobility Transistor, HEMT, en anglais).

Par les termes « transistor GaN », on entend que le substrat du transistor est un alliage à base de nitrure de gallium avec toutefois la possibilité que d'autres éléments puissent être incorporés dans cet alliage de base. Cela englobe notamment les transistors comprenant une ou plusieurs hétérojonctions formées par des alliages tels que AlGaN/InGaN, AlInAs/GaInAs, GaInAs/AlGaAs, AlGaAs/AlGa.

Dans l'exemple représenté, le deuxième noeud N2 de la première puce 100 est relié au noeud de commande 132 du transistor GaN par l'intermédiaire d'un composant électronique 120. Dans un exemple, le composant électronique 120 est configuré pour permettre l'établissement d'un point de fonctionnement automatique du transistor GaN. Dans un autre exemple, le composant électronique 120 est un composant actif ou bien passif. Le composant électronique 120 est par exemple une résistance.

Dans l'exemple représenté, les noeuds N1 et N2 sont déconnectés, autrement dit ne sont pas connectés directement. Cela permet de réaliser des mesures de test, par exemple pour déterminer un paramètre physique du composant 120, par exemple sa résistance et/ou un courant de fuite de la grille 132 du transistor 102.

La figure 2 illustre une vue de dessus d'une partie du circuit électronique 170 du mode de réalisation de la figure 1. Plus particulièrement, la figure 2 représente la première puce 100. Dans l'exemple représenté, un plot de connexion du noeud de conduction 110 du transistor GaN 102, par exemple le drain, est agencé sur une partie haute de la puce 110 sous la forme par exemple d'un rectangle agencé dans et/ou sur un substrat 202 par exemple en GaN. Des plots de connexion reliés aux pistes 130, 132 formant le noeud de commande sont agencés dans un coin à l'opposé du noeud de conduction 110 sur la même surface du substrat 202. Des plots de connexion reliés aux pistes 142, 144 composant la source du transistor 102 sont agencés par exemple dans et/ou sur la même surface du substrat 202 et ce entre les plots reliés aux pistes 130 et 132. Entre les plots de connexion reliés aux pistes 142, 144 se trouve le composant électronique 120, qui dans cet exemple, est une résistance agencée sur la même surface du substrat 202. Le composant électronique 120 est isolé électriquement, sur la première puce 100, des plots de connexion reliés aux pistes 142, 144. De façon non illustré, le composant électronique 120 est par exemple relié aux pistes 130 et 132 par des vias et/ou des pistes conductrices dans le substrat 202.

Les exemples des figures 1 et 2 permettent de mesurer par exemple un ou des paramètres physiques du composant électronique 120. Néanmoins, une fois la mesure ou le test réalisés, pour former un circuit complet, les noeuds N1 et N2 doivent par exemple être connectés électriquement. C'est le cas par exemple si l'on veut implémenter une structure cascode à partir de la première puce 100.

Il est possible de réaliser cette connexion en effectuant une soudure avec un fil (wire bonding an anglais) entre les noeuds N1 et N2. Néanmoins cela est coûteux et cela peut induire des problèmes de fiabilité ainsi qu'introduire des parasites sur les signaux.

Les modes de réalisation décrits prévoient, en complément de la première puce 100, une deuxième puce, empilée avec la première puce de sorte qu'un élément de la deuxième puce connecte électriquement le premier noeud N1 et le deuxième noeud N2 de la première puce. Cela permet de réaliser des mesures sur la première puce, par exemple sur le composant électronique 120, et une fois l'assemblage formé avec la deuxième puce, d'obtenir un circuit complet par exemple un circuit de type cascode. Un autre avantage est que, contrairement à l'utilisation d'un fil soudé, l'apparition d'éléments parasites de type « RLC » est limité. Cela induit en outre une meilleure stabilité lors des transitions de signal et limite les coûts liés aux soudures et au matériau additionnel.

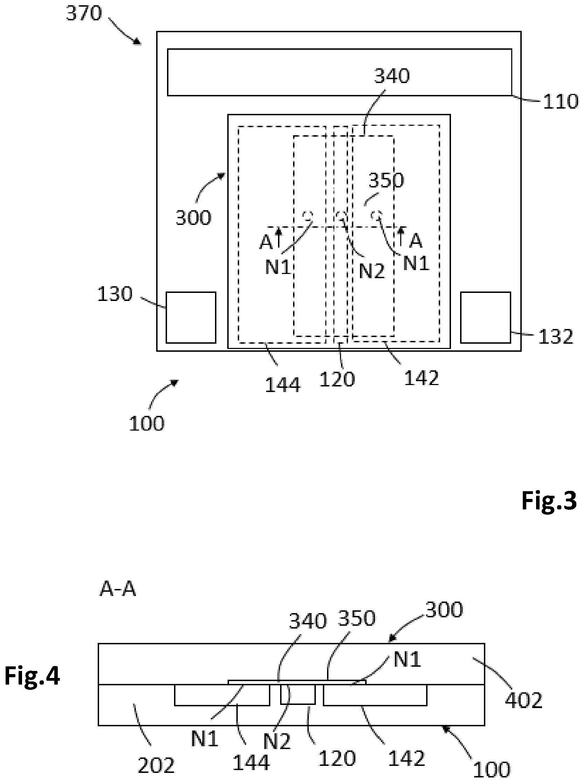

La figure 3 illustre schématiquement une vue de dessus d'un mode de réalisation d'un circuit électronique 370.

Le circuit 370 comprend la première puce 100, similaire à celle décrite aux figures 1 et 2, ainsi qu'une deuxième puce 300. La première et la deuxième puces 100, 300 sont empilées. Dans un exemple, la deuxième puce 300 est une puce à base de silicium ou d'un semiconducteur. Dans un autre exemple la deuxième puce 300 comprend au moins un circuit avec un transistor.

Dans l'exemple représenté, la deuxième puce 300 est empilée au-dessus de la première puce. La deuxième puce 300 comprend un élément 350 agencé sur une face de la deuxième puce 300 qui fait face à la surface située en avant de la première puce 100. L'élément 350 de la deuxième puce comprend par exemple une piste conductrice par exemple métallique ou faite dans un semiconducteur fortement dopé. Cette piste conductrice est par exemple formée par ou connectée à un drain 340 ou une source ou une grille d'un transistor de la deuxième puce 300.

Dans l'exemple de la figure 3, on voit par transparence que la deuxième puce recouvre les plots de connexion reliés aux pistes 142, 144 ainsi que le composant électronique 120.

Dans l'exemple représenté, l'élément 350 recouvre en partie les plots de connexion reliés aux pistes 142, 144. Dans un autre exemple l'élément 350 recouvre entièrement ces plots. Comme montré sur la figure 1, la source du transistor 102 peut être divisée en deux parties 142, 144 toutes deux connectées au noeud N1. L'élément 350 connecte électriquement le premier noeud N1 et le deuxième noeud N2 de la première puce 100, autrement dit l'élément 350 connecte électriquement la source du transistor 102 au deuxième noeud N2 qui est lui-même connecté au composant électronique 120. Dans un exemple où la source du transistor 102 est formée d'une seule piste conductrice, l'élément 350 connecte électriquement cette piste, et ainsi la source du transistor 102, au deuxième noeud N2.

Dans un exemple, un contact électrique entre l'élément de la deuxième puce 300 et les premiers et deuxième noeuds N1, N2 de la première puce est réalisé avec une soudure ou une brasure. Dans un autre exemple, ce contact électrique est réalisé par l'intermédiaire d'un film adhésive conducteur (« die attach adhésive film » en anglais) contenant par exemple de l'argent et/ou du nickel, et/ou du cuivre et/ou de l'or et/ou du palladium. Un traitement thermique accompagné ou non de l'application d'une pression peut également être utilisé pour former le contact.

L'exemple de la figure 3 permet d'augmenter la surface de contact entre la première et la deuxième puce pour réaliser le contact entre les noeuds N1 et N2 contrairement à une connexion par fil dont les surfaces de contact sont réduites et fragiles.

La figure 4 illustre schématiquement une vue en coupe A-A d'une partie du circuit électronique du mode de réalisation de la figure 3. La coupe A-A coupe la première et la deuxième puce 100, 300 au niveau des plots de connexion de la source 142, 144 ainsi que le composant électronique 120 et l'élément 350.

Dans l'exemple représenté, les plots de la source 142, 144 sont agencés dans le substrat 202 à partir de la surface de la première puce 100 qui est en regard de la deuxième puce 300. L'élément 350 est agencé dans un substrat 402 de la deuxième puce 300 à partir de la surface de la deuxième puce faisant face à la première puce. L'élément 350 recouvre en partie les plots de la source 142, 144 du transistor 102 de la première puce 100 au niveau du noeud N1, qui est distribué sur les plots de la source 142, 144. L'élément 350 recouvre également l'élément 120 au niveau du noeud N2 qui est distribué sur la surface du composant 120. Ces recouvrements ainsi que les éventuelles soudures ou brasures associées forment le contact électrique entre la source 142, 144 du transistor 102 et le deuxième noeud N2 qui est connecté à la grille du transistor 102.

Dans un exemple, l'élément 350 est une partie d'un noeud de conduction, par exemple un drain 340, d'un transistor de la deuxième puce. Cela permet de limiter au maximum les longueurs de connexion.

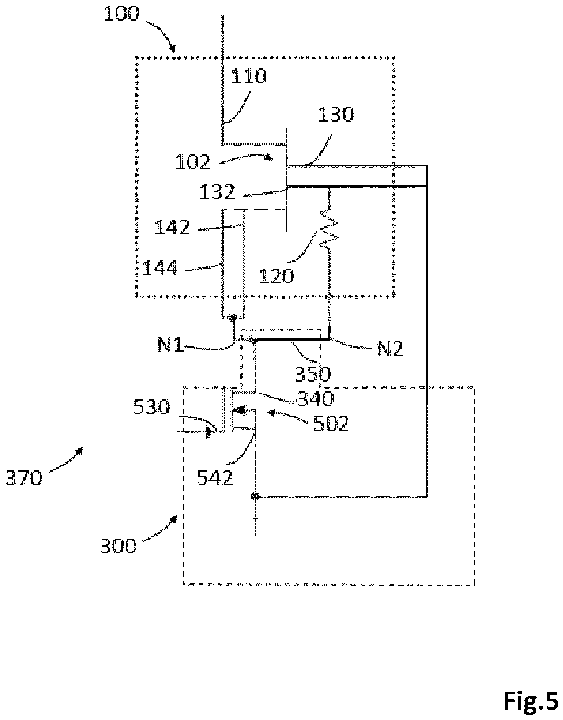

La figure 5 illustre schématiquement le circuit électronique de la figure 3 selon un mode de réalisation.

Dans l'exemple représenté, la première puce 100 comprend un circuit similaire à celui de la figure 1 et l'élément 350 de la deuxième puce 300 est une partie du drain 340 d'un transistor 502 de la deuxième puce 300. Dans un exemple, le transistor 502 de la deuxième puce 300 est de type MOS (Métal Oxyde Semiconducteur) et le substrat 402 est à base de silicium.

Dans l'exemple représenté, la source 542 du transistor 502 est reliée, préférablement connectée, au noeud de commande 130, 132 du transistor GaN 102 de la première puce 100. Cette connexion se fait par exemple de façon similaire à la mise en connexion entre le premier et le deuxième noeud N1, N2. Dans cet exemple, la source 542 du transistor 502 est connectée au substrat du transistor 502. Le drain 340 du transistor 502 est connecté à l'élément 350 et donc également aux noeuds N1 et N2. Le transistor 502 possède en outre un noeud de commande 530.

L'exemple de la figure 5 forme ainsi un circuit de type cascode avec la source 142, 144 du transistor GaN 102 en série avec le drain 340 du transistor 502, et la grille 130, 132 du transistor 102 connectée à la source 542 du transistor 502.

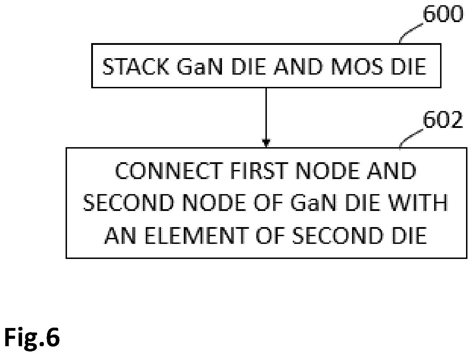

La figure 6 illustre un procédé de fabrication du circuit électronique de la figure 3.

Dans une première étape 600 (STACK GaN DIE AND MOS DIE), la première et la deuxième puces 100, 300 sont superposées par exemple de sorte à mettre en regard l'élément 350 avec les plots de la source 142, 144 ainsi qu'avec la surface du composant électronique 120. Les noeuds N1 et N2 sont à ce stade déconnectés.

Dans une deuxième étape 602 (CONNECT FIRST NODE AND SECOND NODE OF GaN DIE WITH AN ELEMENT OF SECOND DIE), les noeuds N1 et N2 de la première puce 100 sont connectés électriquement par l'élément 350 de la deuxième puce. La mise en connexion est soit directe soit par l'intermédiaire d'une soudure ou d'une brasure et/ou par l'intermédiaire d'alliages et/ou par l'application d'un traitement thermique et/ou d'une pression.

Avant l'étape 600, les noeuds N1 et N2 étant déconnectés, il est possible de tester par exemple la résistance du composant 120 et/ou un courant de fuite de la grille du transistor GaN 102.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, l'élément 350 peut être formé par une pluralité de points ou surfaces conductrices.

Enfin, la mise en oeuvre pratique des modes de réalisation et variantes décrits est à la portée de la personne du métier à partir des indications fonctionnelles données ci-dessus. En particulier, pour ce qui est de l'élément 350, il peut s'agir d'une piste conductrice ou également être matérialisé par un noeud de conduction ou de commande ou encore un noeud de commande d'une grille arrière du transistor 502 de la deuxième puce 300. L'élément 350 peut en outre être matérialisé par une partie d'un composant électronique telle qu'un noeud d'une diode ou d'une inductance ou d'une capacité par exemple.

Dans les exemples décrits, la deuxième puce 300 est empilée sur la première puce 100, il est cependant envisageable pour la personne du métier de prévoir l'inverse.

Les modes de réalisation décrits peuvent être appliqués par exemple pour des applications utilisant de la puissance comme par exemple les applications automobiles.

## Revendications

1. Circuit électronique (370) comprenant une première puce (100), ayant un transistor GaN (102), et une deuxième puce (300), empilées de sorte qu'un élément (350) de la deuxième puce (300) connecte électriquement un premier noeud (N1) et un deuxième noeuds (N2) de la première puce (100) reliés respectivement à un noeud de conduction (140, 142) et à un noeud de commande (130,132) du transistor GaN (102).

2. Procédé de fabrication d'un circuit électronique (370) comprenant :
- empiler une première puce (100), ayant un transistor GaN (102) et une deuxième puce (300), de sorte qu'un élément (350) de la deuxième puce (100) connecte électriquement un premier noeud (N1) et un deuxième noeuds (N2) de la première puce reliés respectivement à un noeud de conduction (142, 144) et à un noeud de commande (130, 132) du transistor GaN (102) .

3. Circuit selon la revendication 1 ou procédé selon la revendication 2, dans lequel ledit élément (350) de la deuxième puce (300) comprend une piste conductrice agencée sur une première face de la deuxième puce (300).

4. Circuit selon la revendication 1 ou 3, ou procédé selon la revendication 2 ou 3, dans lequel la deuxième puce (300) est une puce à base de silicium.

5. Circuit selon l'une quelconque des revendications 1 ou 3 ou 4, ou procédé selon l'une quelconque des revendications 2 à 4, dans lequel la deuxième puce (300) comprend au moins un transistor (502).

6. Circuit ou procédé selon la revendication 5, dans lequel le transistor (502) de la deuxième puce (300) est de type MOS et le transistor GaN (102) de la première puce (100) est de type HEMT.

7. Circuit ou procédé selon la revendication 5 ou 6, dans lequel ledit transistor (502) de la deuxième puce (300) a :
- un premier noeud de conduction (340) connecté au premier noeud (N1) de la première puce (100) par l'intermédiaire dudit élément (350), et
- un deuxième noeud de conduction (542) connecté au noeud de commande (130,132) du transistor (102) de la première puce (100) par l'intermédiaire d'un autre élément.

8. Circuit selon l'une quelconque des revendications 1 ou 3 à 7, ou procédé selon l'une quelconque des revendications 2 à 7, dans lequel un contact électrique entre ledit élément (350) de la deuxième puce et les premiers et deuxième noeuds (N1, N2) de la première puce (100) est une soudure ou une brasure.

9. Circuit selon l'une quelconque des revendications 1 ou 3 à 8, ou procédé selon l'une quelconque des revendications 2 à 8, dans lequel le deuxième noeud (N2) de la première puce est relié au noeud de commande du transistor GaN (102) par l'intermédiaire d'un composant électronique (120).

10. Circuit ou procédé selon la revendication 9, dans lequel ledit composant électronique (120) est actif ou passif.

11. Circuit ou procédé selon la revendication 9 ou 10, dans lequel ledit composant électronique (120) est configuré pour permettre l'établissement d'un point de fonctionnement automatique du transistor GaN (102).

12. Circuit ou procédé selon l'une quelconque des revendications 9 à 11, dans lequel ledit composant électronique (120) est une résistance.

13. Procédé selon l'une quelconque des revendications 2 à 12, dans lequel, avant l'empilement de la première et de la deuxième puces (100,300), les premier et deuxième noeuds (N1, N2) de la première puce (100) sont déconnectés l'un de l'autre.

14. Procédé selon la revendication 13, dans lequel avant l'empilement de la première et de la deuxième puces (100,300), un test du composant électronique (350) est réalisé.
